# EUROPEAN PATENT APPLICATION

(11) **EP 4 044 430 A1**
(43) Date of publication of application: **17.08.2022**
(21) Application number: 20891763.3
(22) Date of filing: 25.11.2020
(51) Int. Cl.: H03F 1/07

(54) **POWER AMPLIFIER COMBINING DEVICE AND POWER AMPLIFIER CIRCUIT**

(30) Priority: 28.11.2019 CN 201911195514
(71) Applicant: Huawei Technologies Co., Ltd., Longgang District, Shenzhen, Guangdong 518129 (CN)
(72) Inventor: ZENG, Zhixiong, Shenzhen, Guangdong 518129 (CN); SUN, Jie, Shenzhen, Guangdong 518129 (CN)
(74) Representative: Gill Jennings & Every LLP
(86) International application number: PCT/CN2020/131513
(87) International publication number: WO 2021/104311

(57) **Abstract**

Embodiments of the present invention disclose a power amplifier combiner apparatus and a power amplifier circuit. The power amplifier combiner apparatus includes a signal processing unit and n power amplifier units, where n is an integer greater than 1. The signal processing unit is separately coupled to input terminals of the n power amplifier units. Output terminals of the n power amplifier units are separately coupled to a load. The signal processing unit is configured to: when an output power of the power amplifier combiner apparatus is less than a first threshold, control a first power amplifier unit to operate; when the output power is greater than or equal to an i^{th} threshold and is less than an (i+1)^{th} threshold, control the first power amplifier unit to an (i+1)^{th} power amplifier unit to operate; and when the output power is greater than or equal to an (n-1)^{th} threshold, control the n power amplifier units to operate, where i=1, ..., or n-2; and the first threshold, ..., and the (n-1)^{th} threshold sequentially increase. According to the embodiments of the present invention, power consumption of a power amplifier unit can be reduced.

## Description

This application claims priority to Chinese Patent Application No. 201911195514.6, filed with the China National Intellectual Property Administration on November 28, 2019 and entitled "POWER AMPLIFIER COMBINER APPARATUS AND POWER AMPLIFIER CIRCUIT", which is incorporated herein by reference in its entirety.

### TECHNICAL FIELD

Embodiments of the present invention relate to the field of electronic circuit technologies, and in particular, to a power amplifier combiner apparatus and a power amplifier circuit.

### BACKGROUND

To increase an output power, a plurality of power amplifier units may be connected in parallel, to be specific, inputs of the plurality of power amplifier units are connected together, outputs of the plurality of power amplifier units are connected together, and bias voltages of the plurality of power amplifier units are set to a same value. An output power obtained after the plurality of power amplifier units are connected in parallel is a sum of output powers of the plurality of power amplifier units. Therefore, the output power can be increased. However, when a small output power is required, an output power of each power amplifier unit is less than a maximum output power of a single power amplifier unit. In this case, conversion efficiency of a power amplifier unit is reduced. Consequently, power consumption of the power amplifier unit is high.

### SUMMARY

Embodiments of the present invention disclose a power amplifier combiner apparatus and a power amplifier circuit, to reduce power consumption of a power amplifier unit.

A first aspect discloses a power amplifier combiner apparatus, including a signal processing unit and n power amplifier units. The signal processing unit is separately coupled to input terminals of the n power amplifier units. Output terminals of the n power amplifier units are separately coupled to a load. The signal processing unit is configured to: when an output power of the power amplifier combiner apparatus is less than a first threshold, control a first power amplifier unit to operate; when the output power is greater than or equal to an i^{th} threshold and is less than an (i+1)^{th} threshold, control the first power amplifier unit to an (i+1)^{th} power amplifier unit to operate; and when the output power is greater than or equal to an (n-1)^{th} threshold, control the n power amplifier units to operate, where n is an integer greater than 1; i=1, ..., or n-2; and the first threshold, ..., and the (n-1)^{th} threshold sequentially increase. When a small output power is required, a small quantity of power amplifier units can provide the required output power. When a large output power is required, a quantity of operating power amplifier unit is increased to provide an additionally required output power. Therefore, as the required output power increases, the quantity of operating power amplifier units can be increased to improve conversion efficiency of the power amplifier units. In this way, power consumption of the power amplifier units can be reduced.

In a possible implementation, the output terminals of the n power amplifier units are separately coupled to the load through a matching network, so that it can be ensured that impedances match.

In a possible implementation, the signal processing unit is further configured to provide radio frequency excitation signals for the n power amplifier units. An amplitude and a phase of the radio frequency excitation signal can be controlled within a very small power level. Therefore, a bandwidth of the signal processing unit is wide, and power consumption is low.

In a possible implementation, the signal processing unit is further configured to provide bias voltages for the n power amplifier units to improve control force of the signal processing unit.

In a possible implementation, bias voltages of the first power amplifier unit, ..., and an n^{th} power amplifier unit sequentially decrease. By using such a bias voltage configuration, together with the corresponding radio frequency excitation signal output by the signal processing unit, the n power amplifier units gradually operate as the output power of the power amplifier combiner apparatus increases. Therefore, the power consumption of the power amplifier units can be reduced.

In a possible implementation, the bias voltages of the first power amplifier unit, ..., and the n^{th} power amplifier unit remain unchanged. A bias state of a power amplifier unit does not need to be adjusted based on an envelope change of an input signal of the power amplifier combiner apparatus. Therefore, even if a size of a power tube in the power amplifier unit is large and a parasitic parameter is large, no additional power consumption of the signal processing unit is caused. As a result, the size and a type of the power tube are not strictly required.

In a possible implementation, the first threshold is a maximum output power of the first power amplifier unit, a j^{th} threshold is a sum of a (j-1)^{th} threshold and a maximum output power of a j^{th} power amplifier unit, and j=2, ..., or n-1.

A second aspect discloses a power amplifier circuit. The power amplifier circuit may include two power amplifier tributaries. At least one of the two power amplifier tributaries is the power amplifier combiner apparatus disclosed in the first aspect or any implementation of the first aspect.

In a possible implementation, the power amplifier circuit may be a Doherty (Doherty) power amplifier, a Chireix (Chireix) power amplifier, an outphasing (Outphasing) power amplifier, or another power amplifier circuit having an equivalent function.

### BRIEF DESCRIPTION OF DRAWINGS

FIG. 1 is a schematic diagram of a structure of a power amplifier combiner apparatus according to an embodiment of the present invention;
FIG. 2 is a schematic diagram of output powers of a power amplifier combiner apparatus that correspond to different quantities of operating power amplifier units according to an embodiment of the present invention;
FIG. 3 is a schematic diagram of a structure of another power amplifier combiner apparatus according to an embodiment of the present invention;
FIG. 4 is a schematic diagram of radio frequency excitation signals and bias voltages provided by a signal processing unit for n power amplifier units according to an embodiment of the present invention;
FIG. 5 is a schematic diagram of a structure of still another power amplifier combiner apparatus according to an embodiment of the present invention;
FIG. 6 is another schematic diagram of output powers of a power amplifier combiner apparatus that correspond to different quantities of operating power amplifier units according to an embodiment of the present invention;
FIG. 7 is a schematic diagram of an output power of a power amplifier combiner apparatus and an impedance of a power amplifier unit according to an embodiment of the present invention;
FIG. 8A and FIG. 8B are a schematic diagram of output powers of a power amplifier combiner apparatus, output powers of power amplifier units, and drain efficiency according to an embodiment of the present invention;
FIG. 9 is a schematic diagram of output powers of a power amplifier combiner apparatus and amplitude differences and phase differences between radio frequency excitation signals of power amplifier units according to an embodiment of the present invention;
FIG. 10A and FIG. 10B are a schematic diagram of output powers of a power amplifier combiner apparatus and impedances according to an embodiment of the present invention;
FIG. 11 is a schematic diagram of load pulling paths of power amplifier units in Smith charts according to an embodiment of the present invention;
FIG. 12 is a schematic diagram of a structure of a power amplifier circuit according to an embodiment of the present invention;
FIG. 13 is a schematic diagram of a structure of a conventional Doherty power amplifier according to an embodiment of the present invention;
FIG. 14 is a schematic diagram of a structure of a novel Doherty power amplifier according to an embodiment of the present invention;
FIG. 15 is a schematic diagram of output powers of a novel Doherty power amplifier and a conventional Doherty power amplifier, gains, and drain efficiency according to an embodiment of the present invention;
FIG. 16 is a schematic diagram of output powers of a novel Doherty power amplifier and a conventional Doherty power amplifier, gains, and PAE according to an embodiment of the present invention;
FIG. 17 is a schematic diagram of output powers of a novel Doherty power amplifier and a conventional Doherty power amplifier, output powers of power amplifier units, and drain efficiency according to an embodiment of the present invention;
FIG. 18 is a schematic diagram of output powers of a novel Doherty power amplifier and a conventional Doherty power amplifier and impedances of combiner points and power amplifier units according to an embodiment of the present invention;
FIG. 19A and FIG. 19B are a schematic diagram of load pulling paths of power amplifier units of a novel Doherty power amplifier and a conventional Doherty power amplifier in Smith charts according to an embodiment of the present invention; and
FIG. 20A and FIG. 20B are a schematic diagram of amplitude differences and phase differences of radio frequency excitation signals of power amplifier units of a novel Doherty power amplifier and a conventional Doherty power amplifier according to an embodiment of the present invention.

### DESCRIPTION OF EMBODIMENTS

Embodiments of the present invention disclose a power amplifier combiner apparatus and a power amplifier circuit, to reduce power consumption of a power amplifier unit. Details are separately described in the following.

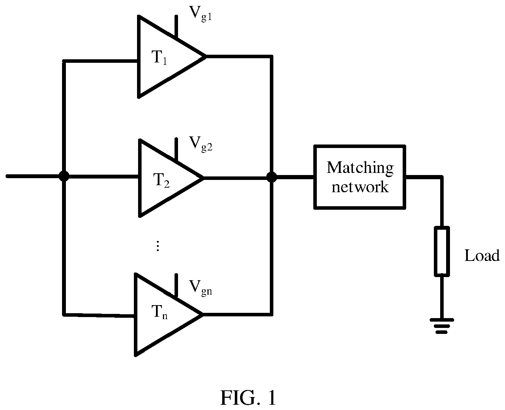

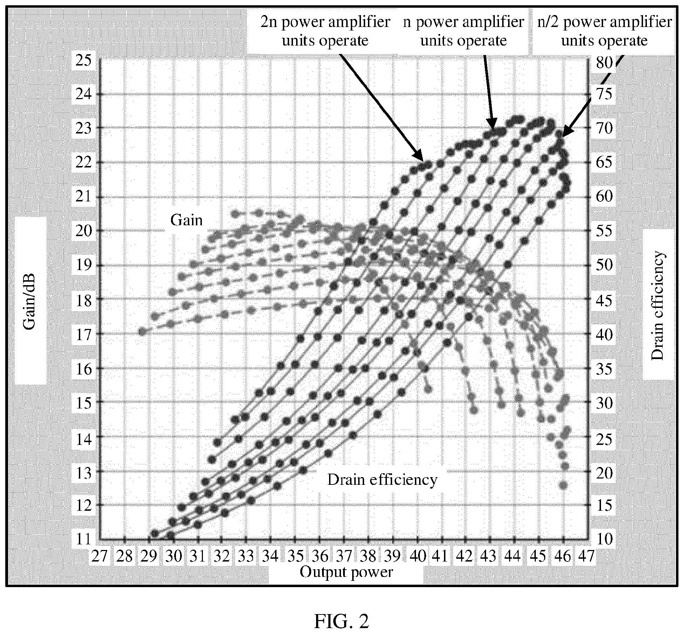

To better understand the power amplifier combiner apparatus and the power amplifier circuit that are disclosed in the embodiments of the present invention, the following first describes application scenarios in the embodiments of the present invention. FIG. 1 is a schematic diagram of a structure of a power amplifier combiner apparatus according to an embodiment of the present invention. As shown in FIG. 1, to implement a power amplifier with a larger output power, inputs of n power amplifier units, namely, a power amplifier unit T₁, a power amplifier unit T₂, ..., and a power amplifier unit Tₙ, may be connected together, outputs of the n power amplifier units may be connected together, and bias voltages of the n power amplifier units are set to a same value, that is, the bias voltage V_{g1}=V_{g2}=...=V_{gn}. In other words, the n power amplifier units are connected in parallel. It is assumed that an impedance of a load is Rₒₚₜ, and a maximum output power of the power amplifier combiner apparatus is Pₒₚₜ. n is an integer greater than 1. An impedance of each of the power amplifier unit T₁, the power amplifier unit T₂, ..., and the power amplifier unit Tₙ is nRₒₚₜ at a connection position, namely, a combiner point, of output terminals thereof. When a required output power is Pₒₚₜ/2, the n power amplifier units may operate together, and an output power of each power amplifier unit is Pₒₚₜ/2n; or n/2 power amplifier units operate, and an output power of each power amplifier unit is Pₒₚₜ/n. FIG. 2 is a schematic diagram of output powers of a power amplifier combiner apparatus that correspond to different quantities of operating power amplifier units according to an embodiment of the present invention. As shown in FIG. 2, in the power amplifier combiner apparatus, even though a same output power can be achieved with different quantities of power amplifier units operating, fewer operating power amplifier units indicate a larger output power of each power amplifier unit and higher peak efficiency, in other words, higher conversion efficiency indicates lower power consumption. Therefore, when a quantity of power amplifier units included in the power amplifier combiner apparatus is constant, how to improve conversion efficiency of a power amplifier unit to reduce power consumption of the power amplifier unit becomes a technical problem that needs to be resolved urgently.

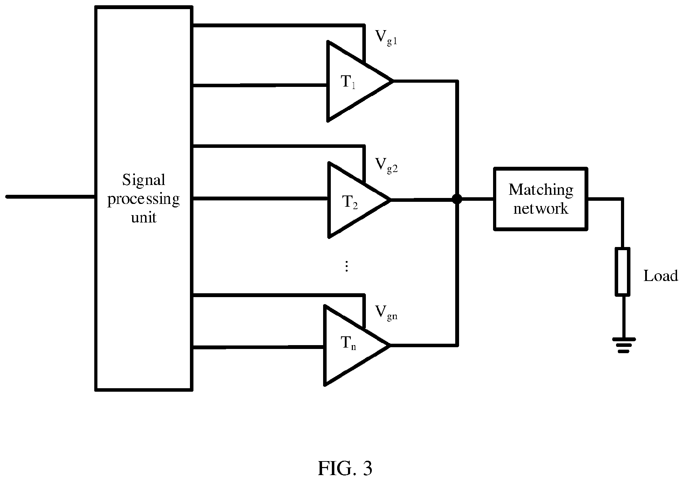

FIG. 3 is a schematic diagram of a structure of another power amplifier combiner apparatus according to an embodiment of the present invention. As shown in FIG. 3, the power amplifier combiner apparatus may include a signal processing unit and n power amplifier units, where n is an integer greater than 1.

The signal processing unit is separately coupled to input terminals of the n power amplifier units, and output terminals of the n power amplifier units are separately coupled to a load.

The signal processing unit is configured to: when an output power of the power amplifier combiner apparatus is less than a first threshold, control a first power amplifier unit T₁ to operate; when the output power of the power amplifier combiner apparatus is greater than or equal to an i^{th} threshold and is less than an (i+1)^{th} threshold, control the first power amplifier unit T₁ to an (i+1)^{th} power amplifier unit Tᵢ₊₁ to operate; and when the output power of the power amplifier combiner apparatus is greater than or equal to an (n-1)^{th} threshold, control the n power amplifier units T₁, T₂, ..., and Tₙ to operate, where i=1, ..., or n-2; and the first threshold, ..., and the (n-1)^{th} threshold sequentially increase.

As shown in FIG. 3, the n power amplifier units T₁, T₂, ..., and Tₙ are not connected in parallel. The signal processing unit can control the n power amplifier units to operate or not to operate. When the output power of the power amplifier combiner apparatus is less than the first threshold, an output power required by the power amplifier combiner apparatus can be provided only with the first power amplifier unit T₁ operating. Therefore, the first power amplifier unit T₁ may be controlled to operate, and remaining power amplifier units are controlled not to operate. When the output power of the power amplifier combiner apparatus is greater than or equal to the i^{th} threshold and is less than the (i+1)^{th} threshold, an output power required by the power amplifier combiner apparatus can be provided with the first power amplifier unit T₁ to the (i+1)^{th} power amplifier unit Tᵢ₊₁ operating. Therefore, the first power amplifier unit T₁ to the (i+1)^{th} power amplifier unit Tᵢ₊₁ may be controlled to operate, and remaining power amplifier units are controlled not to operate. When the output power of the power amplifier combiner apparatus is greater than or equal to the (n-1)^{th} threshold, an output power required by the power amplifier combiner apparatus can be provided only with all the n power amplifier units operating. Therefore, the n power amplifier units may be controlled to operate. For example, when n=4, if the output power of the power amplifier combiner apparatus is less than the first threshold, the first power amplifier unit T₁ may be controlled to operate, and the second power amplifier unit T₂, the third power amplifier unit T₃, and the fourth power amplifier unit T₄ are controlled not to operate; if the output power of the power amplifier combiner apparatus is greater than or equal to the first threshold and is less than a second threshold, the first power amplifier unit T₁ and the second power amplifier unit T₂ may be controlled to operate, and the third power amplifier unit T₃ and the fourth power amplifier unit T₄ are controlled not to operate; if the output power of the power amplifier combiner apparatus is greater than or equal to a second threshold and is less than a third threshold, the first power amplifier unit T₁, the second power amplifier unit T₂, and the third power amplifier unit T₃ may be controlled to operate, and the fourth power amplifier unit T₄ is controlled not to operate; or if the output power of the power amplifier combiner apparatus is greater than or equal to a third threshold, the first power amplifier unit T₁, the second power amplifier unit T₂, the third power amplifier unit T₃, and the fourth power amplifier unit T₄ may be controlled to operate. A power amplifier unit may be a power amplification component such as a metal oxide semiconductor (metal oxide semiconductor, MOS) tube, or may be a unit including a plurality of components and having a power amplification function. The output power of the power amplifier combiner apparatus is a radio frequency output power of the power amplifier combiner apparatus.

In an embodiment, the output terminals of the n power amplifier units are separately coupled to the load through a matching network, in other words, the matching network is separately coupled to the output terminals of the n power amplifier units and the load. The output terminals of the n power amplifier units are connected together first, and then are connected to the matching network, in other words, the output terminals of the n power amplifier units are connected together, so that the output power of the power amplifier combiner apparatus is equal to a sum of output powers of the n power amplifier units. The matching network can ensure that impedances match.

In an embodiment, the signal processing unit is further configured to provide radio frequency excitation signals for the n power amplifier units.

The signal processing unit may provide the radio frequency excitation signals for the n power amplifier units. The radio frequency excitation signals of the n power amplifier units may be all the same, may be completely different, or may be partially the same and partially different. This is not limited herein. If the radio frequency excitation signals of the n power amplifier units include m different radio frequency excitation signals, the signal processing unit may include m control channels. The m control channels may be independent of each other, in other words, the m control channels are not connected to each other. Each control channel generates one radio frequency excitation signal. One radio frequency excitation signal may be used as a radio frequency excitation signal of one power amplifier unit, or may be used as radio frequency excitation signals of a plurality of power amplifier units. This is not limited herein. The signal processing unit may alternatively include one control channel, but the control channel may include m tributaries, and each tributary generates one radio frequency excitation signal. m is an integer greater than 1 and less than or equal to n.

In an embodiment, the signal processing unit is further configured to provide bias voltages for the n power amplifier units.

The signal processing unit may further provide the bias voltages for the n power amplifier units. The bias voltages of the n power amplifier units may be all the same, may be completely different, or may be partially the same and partially different. This is not limited herein. If the bias voltages of the n power amplifier units include m different bias voltages, the signal processing unit may include m control channels. The m control channels may be independent of each other, in other words, the m control channels are not connected to each other. Each control channel generates one bias voltage. One bias voltage may be used as a bias voltage of one power amplifier unit, or may be used as bias voltages of a plurality of power amplifier units. This is not limited herein. The signal processing unit may alternatively include one control channel, but the control channel may include m tributaries, and each tributary generates one bias voltage.

In an embodiment, bias voltages of the first power amplifier unit, ..., and an n^{th} power amplifier unit sequentially decrease.

In an embodiment, the bias voltages of the first power amplifier unit, ..., and the n^{th} power amplifier unit remain unchanged.

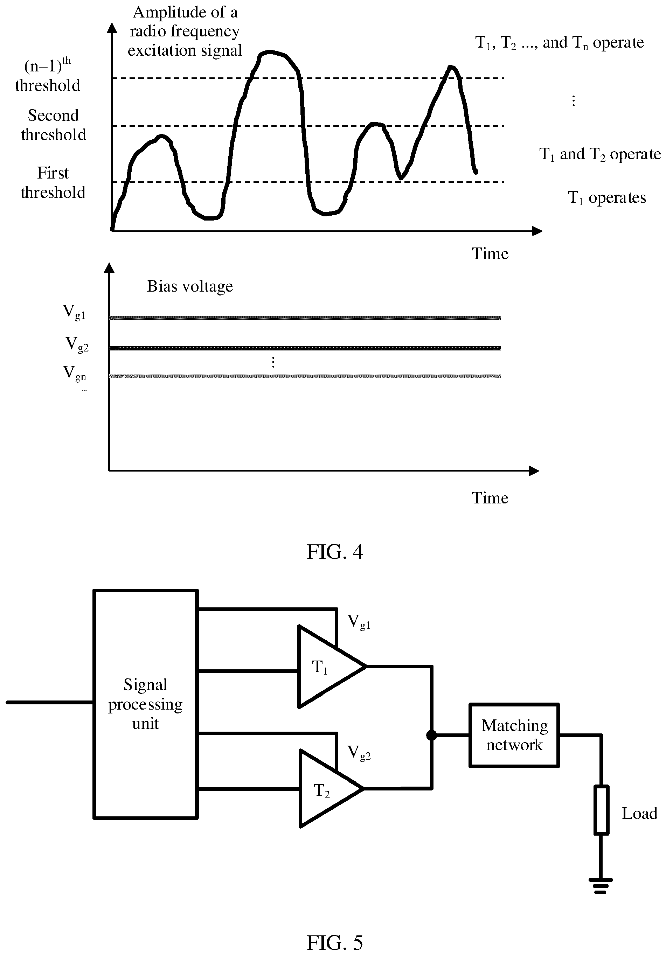

If the radio frequency excitation signals of the n power amplifier units are the same, to ensure the n power amplifier units to operate in different threshold ranges, the bias voltages of the n power amplifier units are completely different. FIG. 4 is a schematic diagram of radio frequency excitation signals and bias voltages provided by a signal processing unit for n power amplifier units according to an embodiment of the present invention. As shown in FIG. 4, a bias voltage V_{g1} of a first power amplifier unit T₁, a bias voltage V_{g2} of a second power amplifier unit T₂, ..., and bias voltage V_{gn} of an n^{th} power amplifier unit Tₙ sequentially decrease. The radio frequency excitation signals of the n power amplifier units are the same. When amplitudes of the radio frequency excitation signals are in different threshold ranges, quantities of operating power amplifier units are different. In addition, a radio frequency excitation signal of a power amplifier unit may not change as a bias voltage changes.

In an embodiment, a first threshold is a maximum output power of the first power amplifier unit, a j^{th} threshold is a sum of a (j-1)^{th} threshold and a maximum output power of a j^{th} power amplifier unit, and j=2, ..., or n-1.

A maximum output power, namely, a maximum radio frequency output power, of each power amplifier unit is constant and does not change with different application scenarios. Maximum output powers of the n power amplifier units may be all the same, may be completely different, or may be partially the same and partially different. This is not limited herein. The first threshold may be the maximum output power of the first power amplifier unit, a second threshold may be a sum of the first threshold and a maximum output power of the second power amplifier unit, ..., and an (n-1)^{th} threshold is a sum of an (n-2)^{th} threshold and a maximum output power of an (n-1)^{th} power amplifier unit. If the maximum output powers of the n power amplifier units include m different maximum output powers, the first power amplifier unit may be a power amplifier unit whose maximum output power is the largest among the maximum output powers of the n power amplifier units, may be a power amplifier unit whose maximum output power is the smallest among the maximum output powers of the n power amplifier units, or may be another power amplifier unit. This is not limited herein.

A ratio of an output power of the power amplifier combiner apparatus to an input power of the power amplifier combiner apparatus is a gain of the power amplifier combiner apparatus. Therefore, when the output power of the power amplifier combiner apparatus is less than the first threshold, the signal processing unit controls the first power amplifier unit to operate; when the output power is greater than or equal to an i^{th} threshold and is less than an (i+1)^{th} threshold, the signal processing unit controls the first power amplifier unit to an (i+1)^{th} power amplifier unit to operate; or when the output power is greater than or equal to an (n-1)^{th} threshold, the signal processing unit controls the n power amplifier units to operate. In other words, when the input power of the power amplifier combiner apparatus is less than a ratio of the first threshold to A, the signal processing unit controls the first power amplifier unit to operate; when the input power of the power amplifier combiner apparatus is greater than or equal to a ratio of the i^{th} threshold to A and is less than a ratio of the (i+1)^{th} threshold to A, the signal processing unit controls the first power amplifier unit to the (i+1)^{th} power amplifier unit to operate; or when the input power of the power amplifier combiner apparatus is greater than or equal to a ratio of the (n-1)^{th} threshold to A, the signal processing unit controls the n power amplifier units to operate. A is the gain of the power amplifier combiner apparatus.

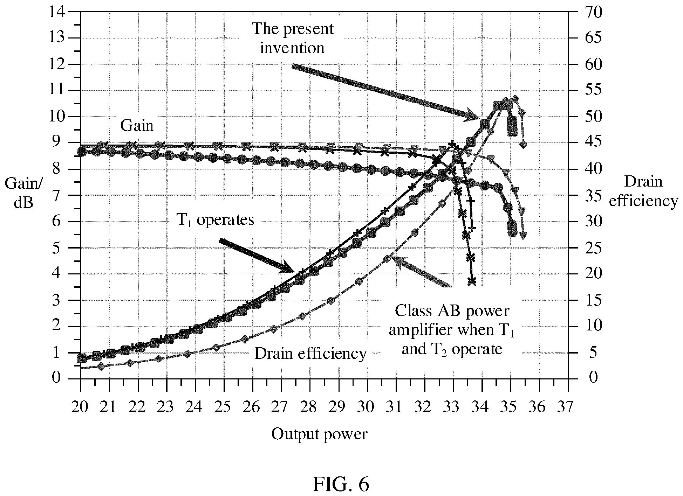

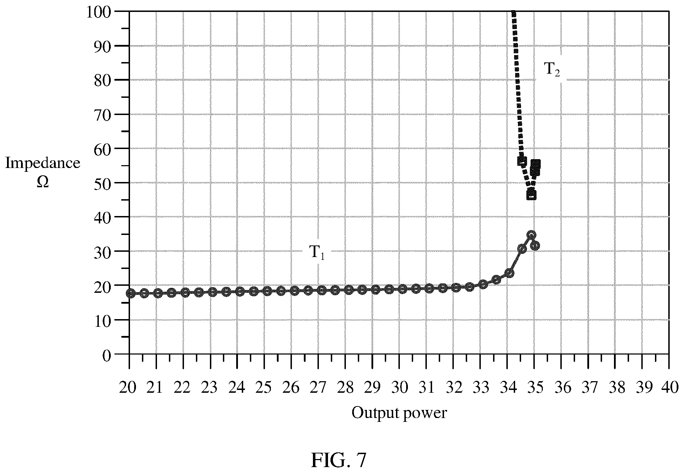

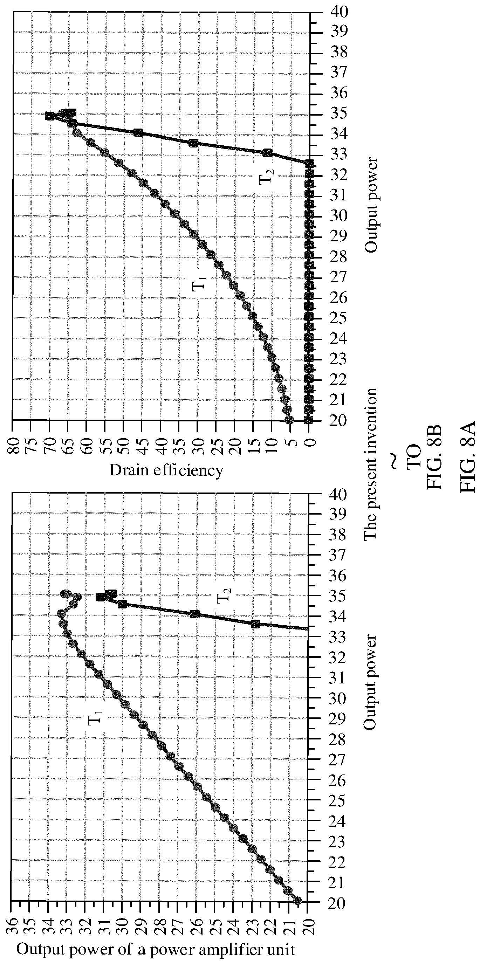

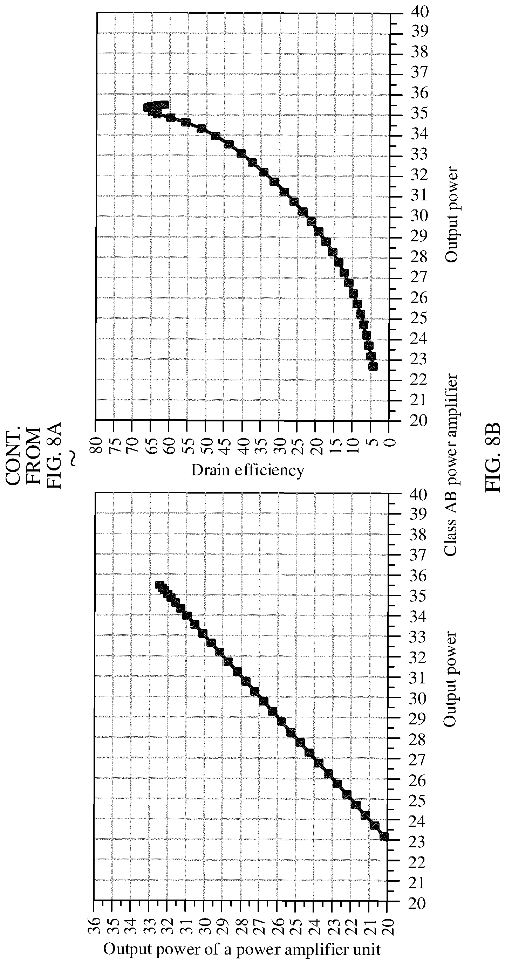

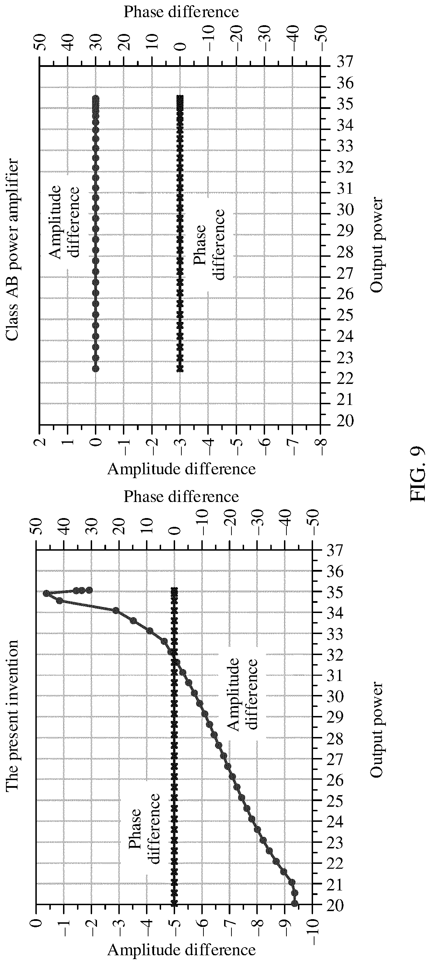

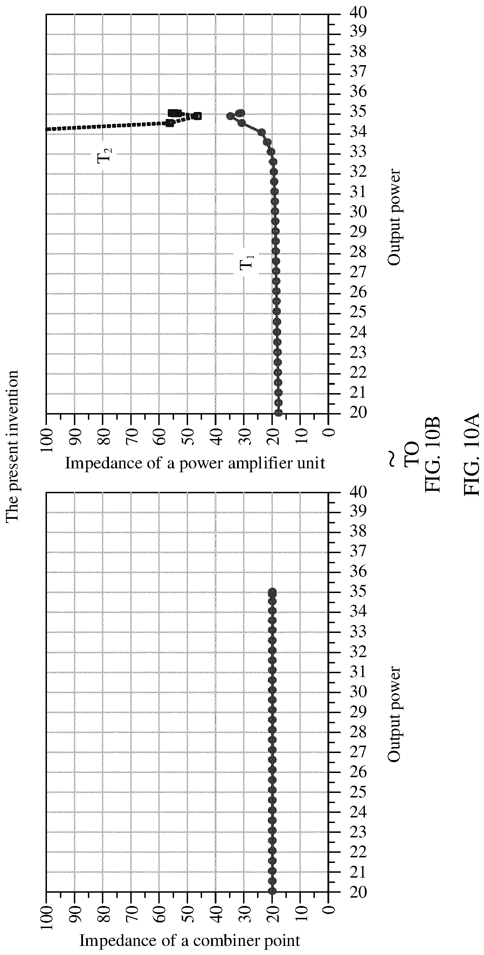

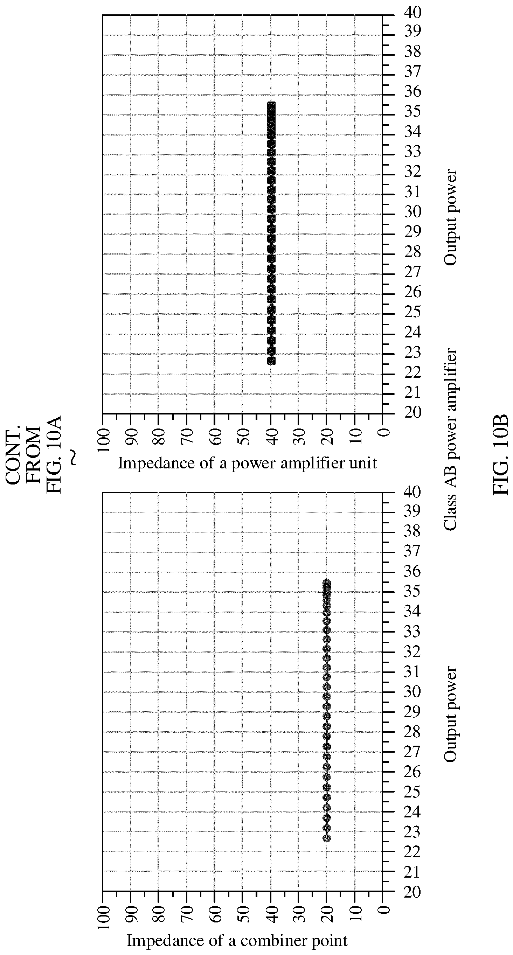

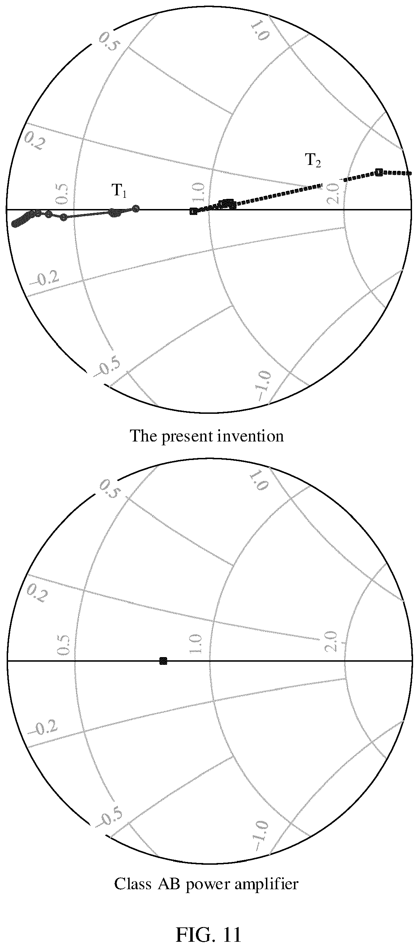

FIG. 5 is a schematic diagram of a structure of still another power amplifier combiner apparatus according to an embodiment of the present invention. As shown in FIG. 5, the power amplifier combiner apparatus may include two power amplifier units. Bias voltages of the two power amplifier units are different. FIG. 6 is another schematic diagram of output powers of a power amplifier combiner apparatus that correspond to different quantities of operating power amplifier units according to an embodiment of the present invention. As shown in FIG. 6, when an amplitude of an input signal of the power amplifier combiner apparatus is small, a power amplifier unit T₁ is in an operating state, a radio frequency excitation signal of a power amplifier unit T₂ is small, and the power amplifier unit T₂ is in a non-operating state, namely, a closed state, or is in a state with a very small output power. As the amplitude of the input signal of the power amplifier combiner apparatus increases, the radio frequency excitation signal of the power amplifier unit T₂ gradually increases, and stops increasing until the output power of the power amplifier unit T₂ stops increasing. When the power amplifier unit T₁ and the power amplifier unit T₂ are completely the same, the radio frequency excitation signal of the power amplifier unit T₂ stops increasing until the output power of the power amplifier unit T₂ is the same as the output power of the power amplifier unit T₁. As can be learned, compared with a class AB power amplifier, the power amplifier combiner apparatus corresponding to FIG. 5, namely, the present invention, can improve rollback efficiency by at least 5 % on average while maintaining the maximum output power. FIG. 7 is a schematic diagram of an output power of a power amplifier combiner apparatus and an impedance of a power amplifier unit according to an embodiment of the present invention. As shown in FIG. 7, when an amplitude of an input signal of the power amplifier combiner apparatus is small, a power amplifier unit T₁ operates, a power amplifier unit T₂ does not operate, an impedance of the power amplifier unit T₁ is small, and an impedance of the power amplifier unit T₂ is large. As the amplitude of the input signal of the power amplifier combiner apparatus increases, both the power amplifier unit T₁ and the power amplifier unit T₂ operate, the impedance of the power amplifier unit T₁ increases, and the impedance of the power amplifier unit T₂ decreases. FIG. 8A and FIG. 8B are a schematic diagram of output powers of a power amplifier combiner apparatus, output powers of power amplifier units, and drain efficiency according to an embodiment of the present invention. As shown in FIG. 8A and FIG. 8B, when the output power of the power amplifier combiner apparatus is less than 33 dBm, only a power amplifier unit T₁ in the present invention has an output power. In this case, a load pulling ratio corresponding to the power amplifier combiner apparatus in the present invention is 3 dB smaller than a load pulling ratio of a class AB power amplifier, and drain efficiency of a power amplifier unit in the power amplifier combiner apparatus corresponding to the present invention is higher than drain efficiency of the class AB power amplifier. FIG. 9 is a schematic diagram of an output power of a power amplifier combiner apparatus and an amplitude difference and a phase difference between radio frequency excitation signals of power amplifier units according to an embodiment of the present invention. As shown in FIG. 9, a phase difference between two power amplifier units in the power amplifier combiner apparatus corresponding to the present invention is constant, that is, does not change as the output power of the power amplifier combiner apparatus changes. An amplitude difference between radio frequency excitation signals of two power amplifier units in the power amplifier combiner apparatus corresponding to the present invention increases as the output power of the power amplifier combiner apparatus increases. In a class AB power amplifier, an amplitude difference and a phase difference between two power amplifier units are constant, that is, do not change as the output power of the power amplifier combiner apparatus changes. FIG. 10A and FIG. 10B are a schematic diagram of output powers of a power amplifier combiner apparatus and impedances according to an embodiment of the present invention. As shown in FIG. 10A and FIG. 10B, neither an impedance of a combiner point between two power amplifier units in the power amplifier combiner apparatus corresponding to the present invention nor an impedance of a combiner point in the class AB power amplifier changes as the output power of the power amplifier combiner apparatus changes. When the output power of the power amplifier combiner apparatus corresponding to the present invention is less than 33 dBm, only a power amplifier unit T₁ operates, and a load pulling ratio is 3 dB less than that of two power amplifier units in the class AB power amplifier. The load pulling ratio starts to increase after 33 dBm and when the power amplifier unit T₂ starts to operate, and is close to load pulling of the class AB power amplifier. However, the load pulling ratio of two power amplifier units in the class AB power amplifier is always constant and is larger. FIG. 11 is a schematic diagram of load pulling paths of power amplifier units in Smith charts according to an embodiment of the present invention. As shown in FIG. 11, load pulling paths of a power amplifier unit T₁ and a power amplifier unit T₁ that are included in a power amplifier combiner apparatus in the present invention are different and are changing, and load pulling paths of two power amplifier units in a class AB power amplifier are the same and do not change.

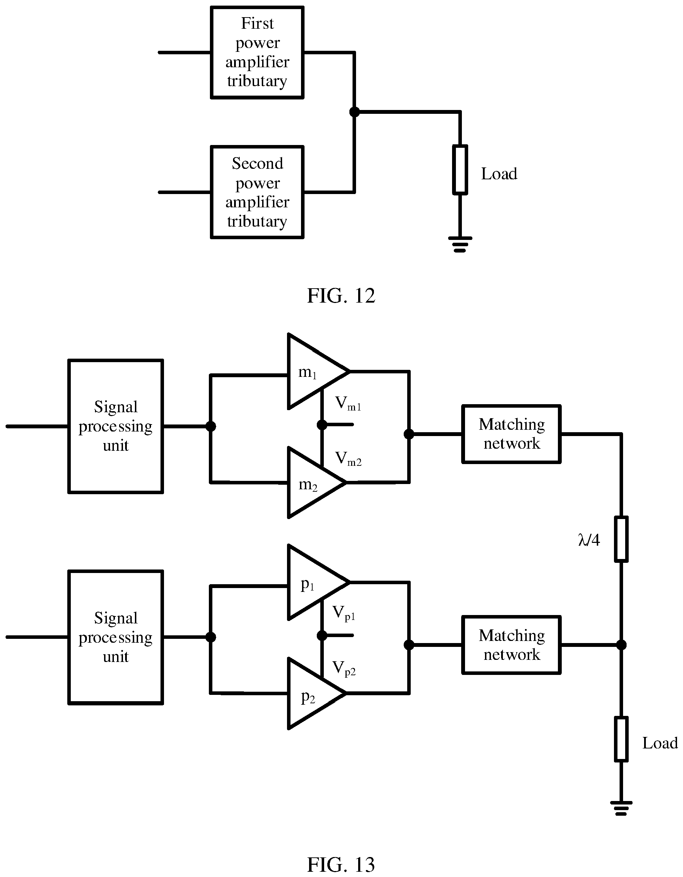

FIG. 12 is a schematic diagram of a structure of a power amplifier circuit according to an embodiment of the present invention. As shown in FIG. 12, the power amplifier circuit may include two power amplifier tributaries, namely, a first power amplifier tributary and a second power amplifier tributary. Output terminals of the two power amplifier tributaries are coupled to a load after being connected, that is, the two power amplifier tributaries are separately coupled to the load. At least one of the two power amplifier tributaries is the power amplifier combiner apparatus shown in FIG. 3. The power amplifier circuit may be a Doherty power amplifier, a Chireix power amplifier, an outphasing power amplifier, or another power amplifier having an equivalent function.

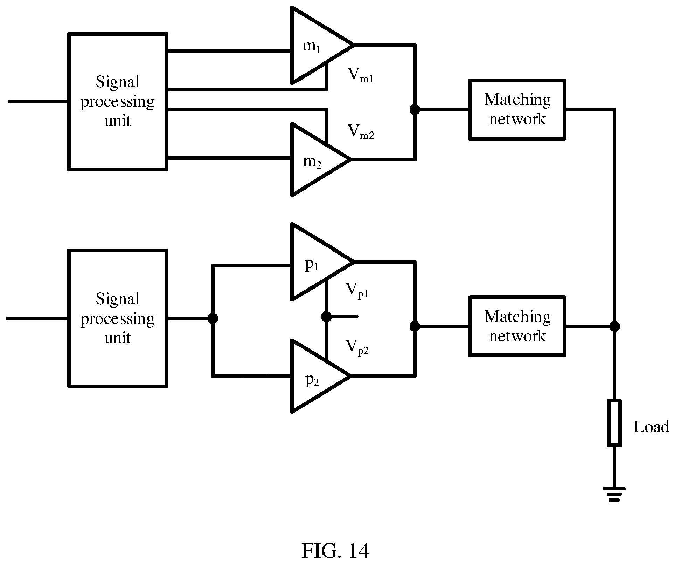

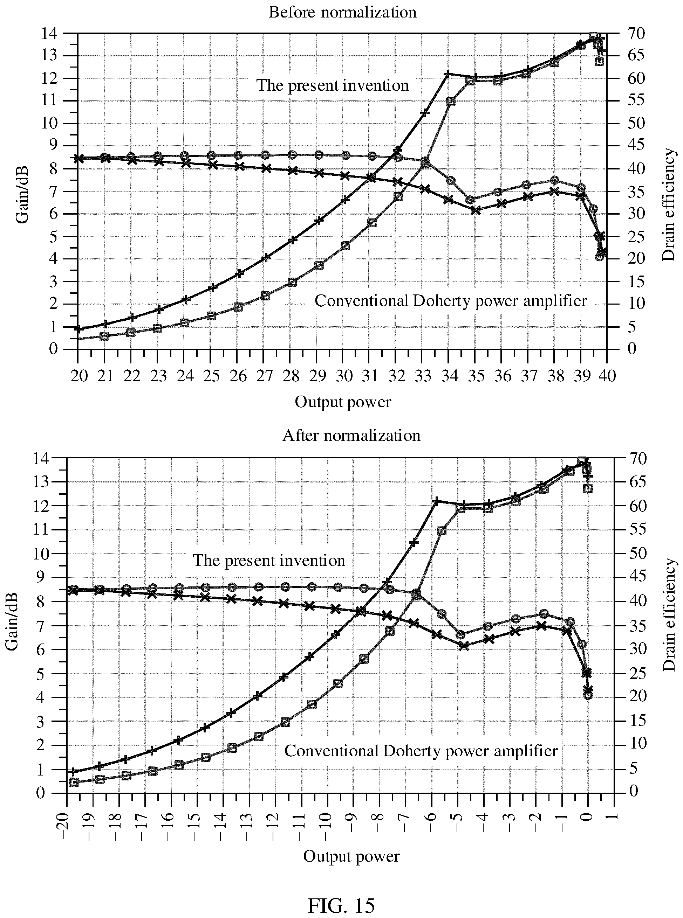

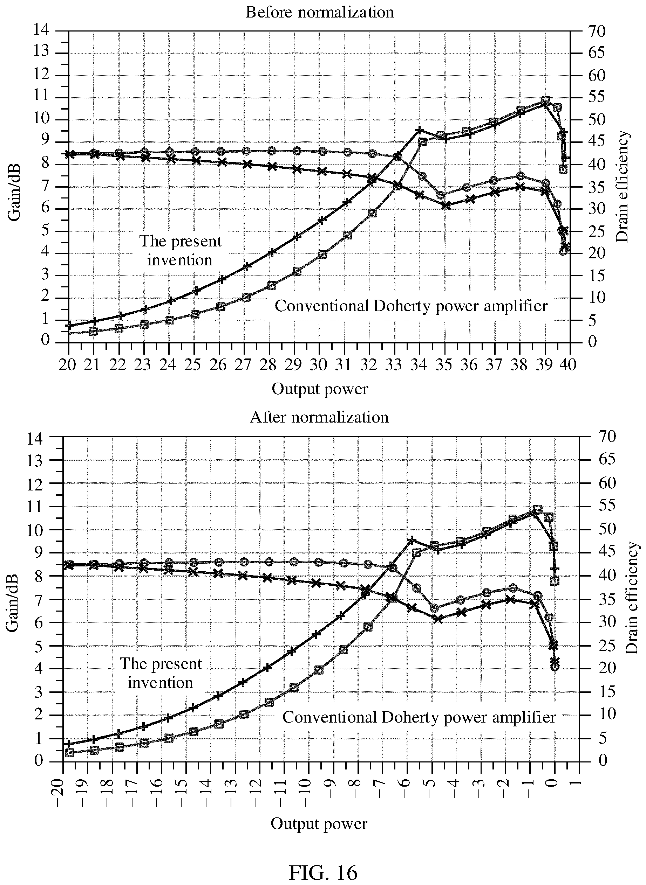

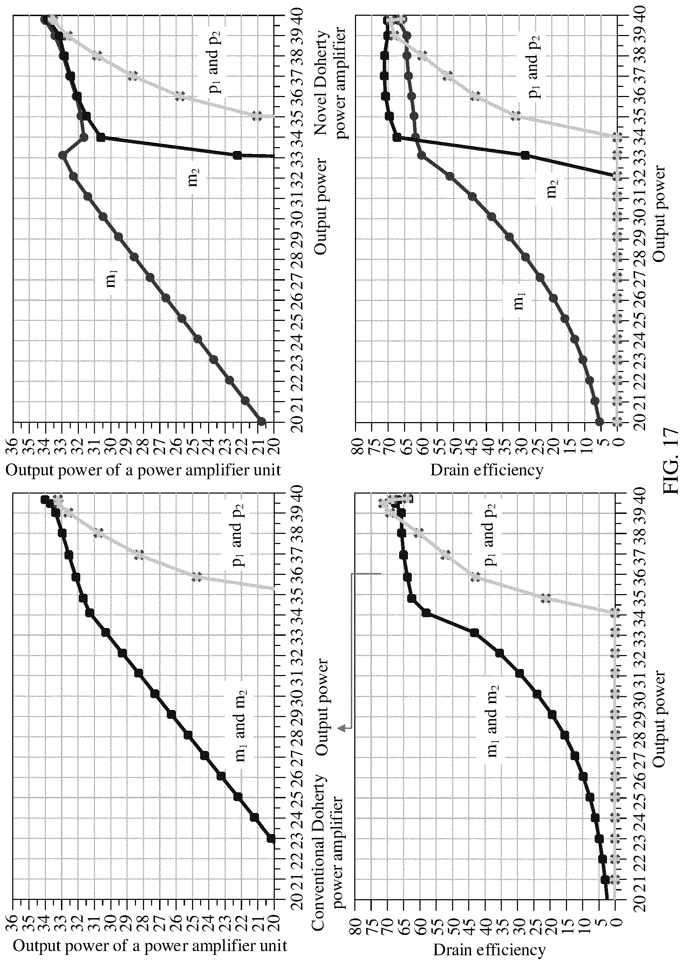

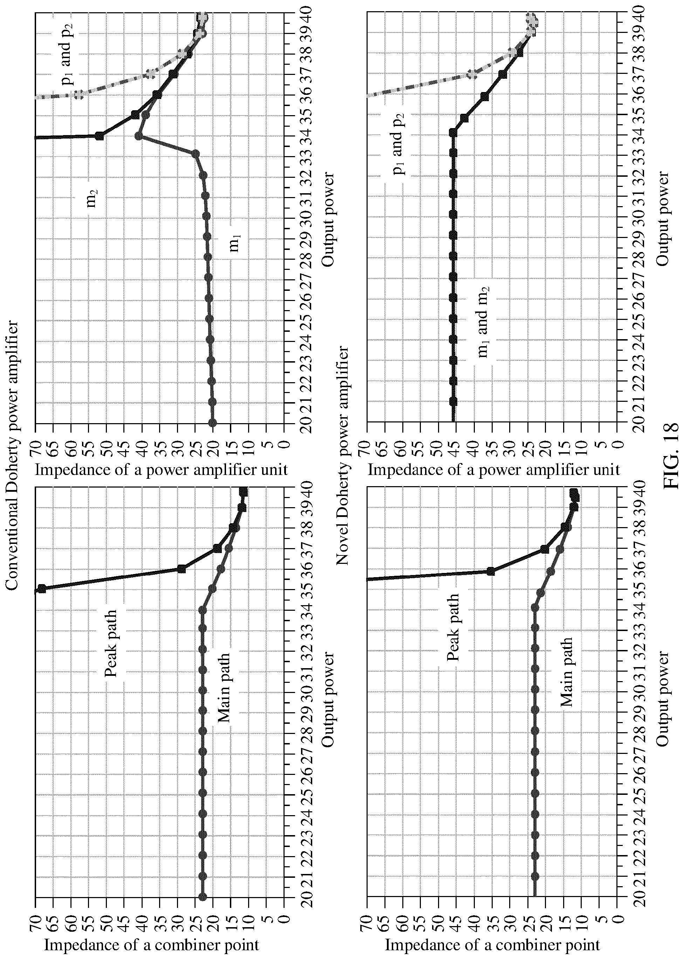

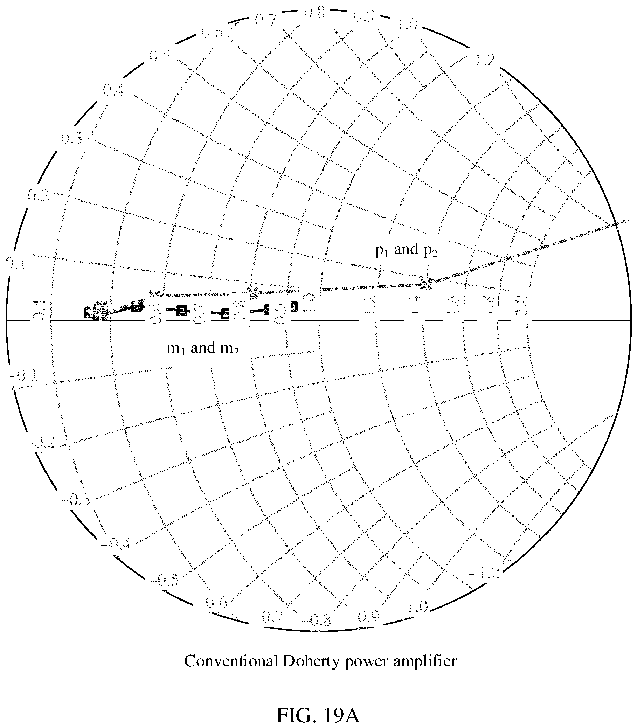

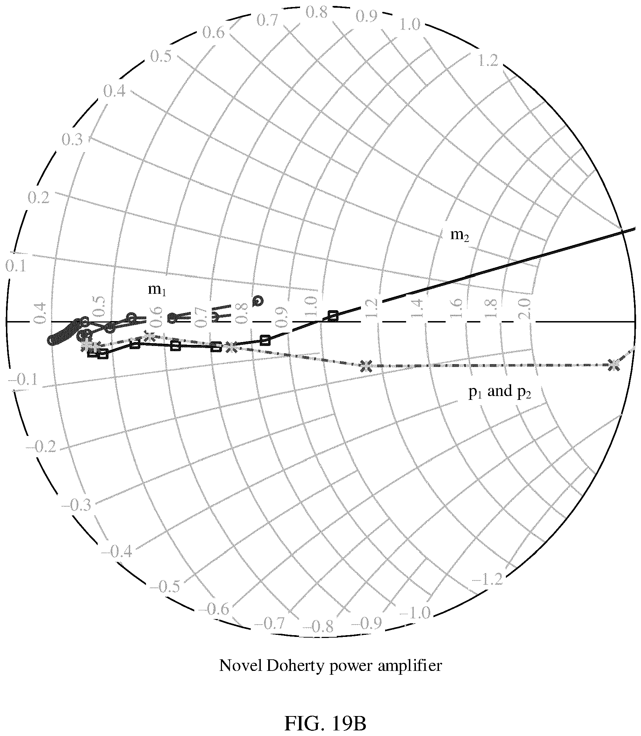

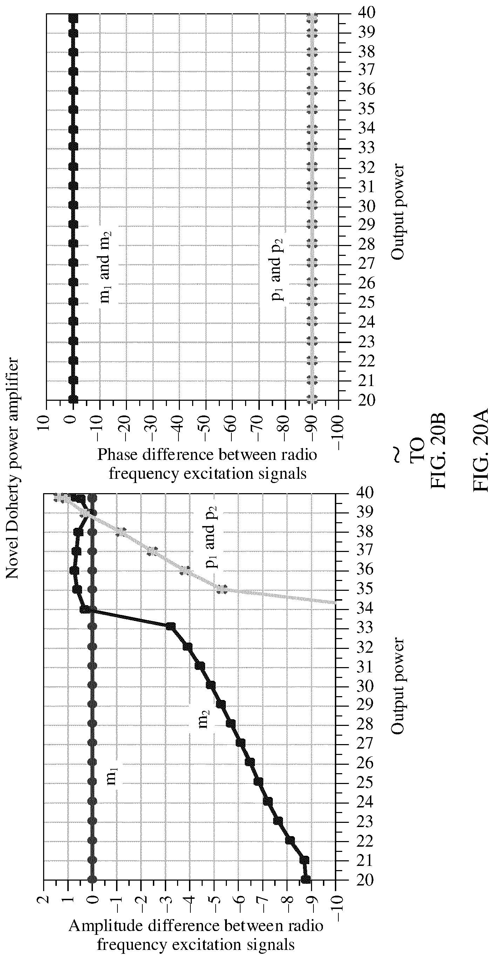

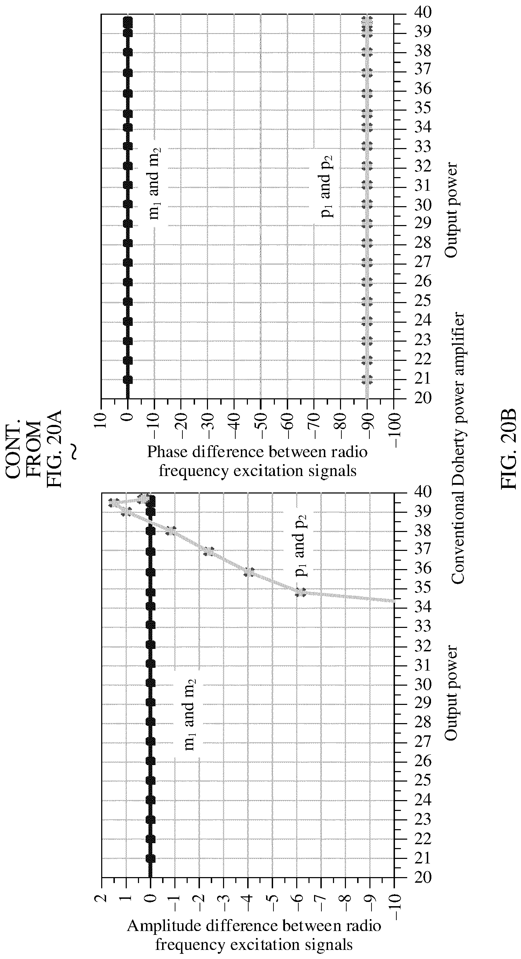

FIG. 13 is a schematic diagram of a structure of a conventional Doherty power amplifier according to an embodiment of the present invention. As shown in FIG. 13, the conventional Doherty power amplifier includes two power amplifier tributaries: a main (main) path and a peak (peak) path. The main path includes two power amplifier units, namely, a power amplifier unit m₁ and a power amplifier unit m₂. Bias voltages of the two power amplifier units are the same, and radio frequency excitation signals of the two power amplifier units are also the same. The peak path includes two power amplifier units, namely, a power amplifier unit p₁ and a power amplifier unit p₂. Radio frequency excitation signals of the two power amplifier units are the same, and bias voltages of the two power amplifier units are also the same. The main path is separately coupled to the peak path and a load through a λ/4 connection line. FIG. 14 is a schematic diagram of a structure of a novel Doherty power amplifier according to an embodiment of the present invention. As shown in FIG. 14, a main path of the Doherty power amplifier is obtained by replacing the power amplifier combiner apparatus shown in FIG. 4. Radio frequency excitation signals of two power amplifier units on the main path obtained after replacement are different, and bias voltage of the two power amplifier units on the main path are also different. FIG. 15 is a schematic diagram of output powers of a novel Doherty power amplifier and a conventional Doherty power amplifier, gains, and drain efficiency according to an embodiment of the present invention. FIG. 16 is a schematic diagram of output powers of a novel Doherty power amplifier and a conventional Doherty power amplifier, gains, and power added efficiency (power added efficiency, PAE) according to an embodiment of the present invention. As shown in FIG. 15 and FIG. 16, the novel Doherty power amplifier can obtain higher rollback efficiency compared with the conventional Doherty power amplifier, and efficiency can be improved by 10% before normalization and when the novel Doherty power amplifier rolls back by 8 dB, PAE is also improved by 7%. Higher drain efficiency and PAE can be achieved after normalization is performed based on a rollback rate. FIG. 17 is a schematic diagram of output powers of a novel Doherty power amplifier and a conventional Doherty power amplifier, output powers of power amplifier units, and drain efficiency according to an embodiment of the present invention. As shown in FIG. 17, when the output power of the Doherty power amplifier is less than 33 dBm, only one power amplifier unit m₁ on a main path of the novel Doherty power amplifier operates. In this case, a load pulling ratio of a power amplifier unit in the novel Doherty power amplifier is 3 dB less than a load pulling ratio of a class AB power amplifier unit in the conventional Doherty power amplifier, and drain efficiency of the power amplifier unit in the novel Doherty power amplifier is 10% to 15% higher than drain efficiency in the conventional Doherty power amplifier. However, due to a loss caused by access of a power amplifier unit m₂ on the main path, combining efficiency of the novel Doherty power amplifier is only 7% to 10% higher than combining efficiency of the conventional Doherty power amplifier. An output power of the power amplifier unit m₁ on the main path of the novel Doherty power amplifier is a sum of output powers of two power amplifier units on the main path of the conventional Doherty power amplifier. Load pulling ratios of the power amplifier unit m₁ on the main path of the novel Doherty power amplifier are less than those of the two power amplifier units on the main path of the conventional Doherty power amplifier. Therefore, drain efficiency is higher. FIG. 18 is a schematic diagram of output powers of a novel Doherty power amplifier and a conventional Doherty power amplifier and impedances of combiner points and power amplifier units according to an embodiment of the present invention. As shown in FIG. 18, loads of the combiner points in the novel Doherty power amplifier and the conventional Doherty power amplifier are the same. When a power amplifier unit m₁ on a main path of the novel Doherty power amplifier is less than 33 dBm, a load pulling ratio of the power amplifier unit m₁ in the novel Doherty power amplifier is 3 dB less than that of two power amplifier units on a main path of the conventional Doherty power amplifier. When a combining output power is greater than 33 dBm and a power amplifier unit m₂ on the main path of the novel Doherty power amplifier starts to operate, the load pulling ratio starts to increase. When the output power is 34 dBm, the output power is close to that of the conventional Doherty power amplifier. The load pulling ratio of the two power amplifier units on the main path of the conventional Doherty power amplifier always remains unchanged when the output power is less than 34 dBm. FIG. 19A and FIG. 19B are a schematic diagram of load pulling paths of power amplifier units of a novel Doherty power amplifier and a conventional Doherty power amplifier in Smith charts according to an embodiment of the present invention. As shown in FIG. 19A and FIG. 19B, load pulling paths of two power amplifier units on a main path of the conventional Doherty power amplifier are the same, and load pulling paths of two power amplifier units on a peak path of the conventional Doherty power amplifier are the same. Load pulling paths of power amplifier unit m₁ and a power amplifier unit m₂ on a main path of the novel Doherty power amplifier are different, and load pulling paths of two power amplifier units on a peak path of the novel Doherty power amplifier are the same. FIG. 20A and FIG. 20B are a schematic diagram of amplitude differences and phase differences of radio frequency excitation signals of power amplifier units of a novel Doherty power amplifier and a conventional Doherty power amplifier according to an embodiment of the present invention. As shown in FIG. 20A and FIG. 20B, the phase differences of the radio frequency excitation signals of the power amplifier units of the novel Doherty power amplifier do not change as an output power changes. The signal amplitude differences of the power amplifier units of the novel Doherty power amplifier are similar to a class B or class C gain. The amplitude differences and the phase differences of the radio frequency excitation signals of the power amplifier units of the conventional Doherty power amplifier do not change as an output power changes.

The objectives, technical solutions, and beneficial effects of this application are further described in detail in the foregoing specific implementations. It should be understood that the foregoing descriptions are merely specific implementations of this application, but are not intended to limit the protection scope of this application. Any modification, equivalent replacement, or improvement made based on the technical solutions of this application shall fall within the protection scope of this application.

## Claims

1. A power amplifier combiner apparatus, comprising a signal processing unit and n power amplifier units, wherein n is an integer greater than 1, wherein
the signal processing unit is separately coupled to input terminals of the n power amplifier units, and output terminals of the n power amplifier units are separately coupled to a load; and
the signal processing unit is configured to: when an output power of the power amplifier combiner apparatus is less than a first threshold, control a first power amplifier unit to operate; when the output power is greater than or equal to an i^{th} threshold and is less than an (i+1)^{th} threshold, control the first power amplifier unit to an (i+1)^{th} power amplifier unit to operate; and when the output power is greater than or equal to an (n-1)^{th} threshold, control the n power amplifier units to operate, wherein i=1, ..., or n-2, and the first threshold, ..., and the (n-1)^{th} threshold sequentially increase.

2. The apparatus according to claim 1, wherein that output terminals of the n power amplifier units are separately coupled to a load comprises:
the output terminals of the n power amplifier units are separately coupled to the load through a matching network.

3. The apparatus according to claim 1 or 2, wherein the signal processing unit is further configured to provide radio frequency excitation signals for the n power amplifier units.

4. The apparatus according to any one of claims 1 to 3, wherein the signal processing unit is further configured to provide bias voltages for the n power amplifier units.

5. The apparatus according to claim 4, wherein bias voltages of the first power amplifier unit, ..., and an n^{th} power amplifier unit sequentially decrease.

6. The apparatus according to claim 5, wherein the bias voltages of the first power amplifier unit, ..., and the n^{th} power amplifier unit remain unchanged.

7. The apparatus according to any one of claims 1 to 6, wherein the first threshold is a maximum output power of the first power amplifier unit, a j^{th} threshold is a sum of a (j-1)^{th} threshold and a maximum output power of a j^{th} power amplifier unit, and j=2, ..., or n-1.

8. A power amplifier circuit, comprising two power amplifier tributaries, wherein at least one of the two power amplifier tributaries is the power amplifier combiner apparatus according to any one of claims 1 to 7.
